(19) Europäisches Patentamt
European Patent Office
Office européen des brevets

(11) **EP 4 481 492 A1**

(12) **EUROPEAN PATENT APPLICATION**

(43) Date of publication:
**25.12.2024 Bulletin 2024/52**

(21) Application number: **23180758.7**

(22) Date of filing: **21.06.2023**

(51) International Patent Classification (IPC):
*G03F 7/00* (2006.01)

(52) Cooperative Patent Classification (CPC):
**G03F 7/706; G03F 7/705; G03F 7/70504;
G03F 7/706839**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
• **HACK, Sjoerd, Arthur**
  **5500 AH Veldhoven (NL)**
• **ALPEGGIANI, Filippo**
  **5500 AH Veldhoven (NL)**
• **COENE, Willem, Marie, Julia, Marcel**
  **5500 AH veldhoven (NL)**

(74) Representative: **ASML Netherlands B.V.
Corporate Intellectual Property
P.O. Box 324
5500 AH Veldhoven (NL)**

(54) **METHOD OF PREDICTING A RESPONSE OF AN ELECTROMAGNETIC SYSTEM TO ILLUMINATION ELECTROMAGNETIC RADIATION**

(57)     A computer-implemented method of predicting a response of an electromagnetic system to electromagnetic radiation from an illumination configuration. The system comprises an aberration element located in a radiation path which causes aberrations described by an aberration function to electromagnetic radiation transmitted along the radiation path, and an object at an object plane on the radiation path which interacts with the electromagnetic radiation. The method comprises various steps.

Figure 6

EP 4 481 492 A1

**Description**

<u>FIELD</u>

The present invention relates to a computer implemented method of predicting an electromagnetic (e.g., optical) response of an electromagnetic (e.g., optical) system to electromagnetic radiation from an illumination configuration. The invention further relates to a computer system arranged to perform the method, and to a computer program product comprising instructions for carrying out the same when implemented by a computer processor.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

A forward solver is an algorithm for computing the response of a system to a given illumination configuration. Optical forward solvers are used to compute the optical response in optical systems, and are typically implemented as ray trace solvers.

Accurate forward solvers have to be capable of modelling the effects of aberrations in the optical system. While ray trace solvers can model aberrations, they are unable to model diffraction and coherence, which makes them unsuitable for many use cases. Some closed-source ray tracing programs, such as FRED, are able to model aberrations and basic forms of diffraction but they are computationally inefficient to run and difficult to integrate into existing prediction tools.

There are a number of different types of aberrations. Optical systems may include any combination of spherical aberrations, offset coma, linear coma, linear astigmatism and the like.

An improved forward solver capable of modelling the effects of aberrations is desirable.

<u>SUMMARY</u>

Aspects of the present disclosure provide a method and computer program product, as set out in the appended set of claims.

The present disclosure aims to provide new and useful methods, systems and computer program products for modelling the passage of electromagnetic radiation though a system (an "electromagnetic system") including an object (e.g. a fabrication product) at an object plane. It further relates to methods for using the modelling to select a metrology target design and/or a lithography mask design.

In general terms, the source (an "illumination configuration") is modelled as a single coherent source or multiple coherent sources which are incoherent with respect to each other. Each of these coherent sources is modelled as an impulse (e.g. a delta function). Each impulse will form a wavelet spread over a finite area in a first plane within the system, having a respective centre point. To compute a response at a second plane (e.g. an exit pupil plane of the electromagnetic system), based on the wavefield(s) generated by the corresponding wavelets (e.g. a sum may be carried out over the wavefield(s) generated by the corresponding wavelet(s)). Advantageously, each wavefield can be computed using a corresponding Fourier transform of electrical field at the object plane (i.e., the corresponding wavelet). Each Fourier transform is modified to take into account aberration to the wavelet caused by an aberration object (e.g. a lens of the electromagnetic system), based on an expansion of an aberration function describing the aberration (e.g. an aberration function determined experimentally by measurement of the aberration object) about a position corresponding to the centre position.

Experimentally, it has been found that this allows the wavefield to be evaluated with acceptable accuracy, without unacceptable computational effort.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic representation of a scatterometer.
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 is a schematic illustration of a portion of an electromagnetic system;
- Figure 7 is a schematic illustration of a 4-f fibre model for modelling the propagation of incoherent pulses of electromagnetic radiation through a fibre;
- Figure 8 is a schematic illustration of the electromagnetic system of Figure 6 under the local field isoplanatism approximation;
- Figure 9 is a schematic illustration of the electromagnetic system of Figure 6 under the local pupil isoplanatism approximation;
- Figure 10 is a method flow diagram;
- Figure 11 is a schematic illustration of the portion of the electromagnetic system from Figure 6, further including a lens element downstream of the object plane; and
- Figure 12 schematically depicts an example computer system in which embodiments can be implemented.

DETAILED DESCRIPTION

A lithographic apparatus is complex and optimising its operational settings for forming a fabrication product (e.g., a patterned wafer) is non-trivial. One approach is to form a target of known geometry (e.g., a grating) onto a wafer using a mask and then image the target using a metrology apparatus. The settings can then be updated based on the difference between an expected diffraction-based overlay (DBO) image from the target, and a real DBO image from the target, obtained using a metrology apparatus. However, a portion of the difference between the images is due to aberrations caused by the metrology apparatus itself and aberrations caused by the mask used during printing. Without a proper knowledge of these aberrations, the possible optimisation of the settings of the lithography apparatus is limited because it is not possible to deduce whether the differences are caused by sub-optimal settings. It is desirable to reduce and/or at least be aware of the aberrations present in the lithographic and metrology apparatus.

The present document proposes a method to predict an electromagnetic response of an electromagnetic system with an aberration element to electromagnetic radiation from an illumination configuration. The response may be optical and sampled at an exit pupil plane within the system. The illumination configuration can be modelled as the propagation of one or more independent pulses to the exit pupil plane, where each pulse is modelled as a delta function at another plane of the system. The delta functions generate waves that propagate along respective electromagnetic paths through the electromagnetic system. In general, these waves form wavelets in certain planes perpendicular to the axis of the electromagnetic system. The aberrations can be described by an aberration function. The aberration function can be obtained by measurement of an aberration object.

A problem is that, in general, the aberration function depends on both field position (e.g., position coordinate at an object plane) and pupil position (e.g., position coordinate at the exit pupil). This is referred to herein as a "4D aberration" (two "dimensions" for each position coordinate). Example 4D aberrations include linear coma, offset coma and linear astigmatism. The 4D dependence breaks down the Fourier transform (FT) relationships which exist between electric fields at planes within the electromagnetic system. The prediction of electromagnetic responses in the electromagnetic system then requires the evaluation of more complex integrals, as opposed to FTs.

In some examples, the present document proposes addressing this problem by evaluating the aberration function based on: (i) field position and a centre position of a wavelet localised in the pupil plane (local pupil isoplanatism); or (ii) pupil position and a centre position of a wavelet localised in the field plane (local field isoplanatism). The centre position of the wavelet can be determined by propagating respective delta functions through the optical system. Each delta is associated with a respective wavelet at one of the field or pupil plane. The dependence of the aberration function on the position of the wavelet in the field/pupil plane is modelled as a zeroth or first order expansion about the centre position of the wavelet. For local field and local pupil isoplanatism, this advantageously restores the FT relationship between the electric field at the object and exit pupil planes. As a result, the contribution made to the response of the system at the exit plane from each wavefield, respectively generated by a corresponding wavelet at the object plane can be computed much more efficiently.

The contributions of each wavelet to the field generated (i.e., the wavefield at the exit pupil plane) can then be summed to compute the optical response to the illumination configuration.

In specific example, the illumination configuration is modelled as one coherent source only, which forms one wavelet only at the object and one wavefield only at the object plane.

The response may be an electric field intensity or a partial coherence function. In a specific example, the optical response is a diffraction-based overlay (DBO) image. Known post processing techniques can be applied to the DBO image to derive further properties relating to the system, such as overlay number.

In other examples, the electromagnetic system includes further (optical) elements downstream of the aberration element. These further elements may be aberration-free or cause aberrations of their own described by corresponding aberration functions. The response may relate to a plane downstream of these further optical elements (e.g., an exit pupil plane of an aberration-free lens).

The contributions from each wavefield to electric field intensity can be summed according to:

$$I(\vec{r}) = \sum_i |\varphi_i(\vec{r})|^2$$

where I(r) is the intensity of the field at a position at a given plane (e.g., the exit pupil plane), r, and $\varphi_i$ is the ith wavefield at that plane evaluated at the position, r.

The contributions from each wavefield to the partial coherence function can be summed according to:

$$J(\vec{r}_1, \vec{r}_2) = \sum_i \varphi_i(\vec{r}_1)\varphi_i^*(\vec{r}_2)$$

Where J is the partial coherence function at position $r_1$, $r_2$ at a given plane (e.g., the exit pupil plane), $\varphi_i$ is the ith wavefield at that plane evaluated at position, $r_1$ and $\varphi_i^*$ is the complex conjugate of the ith wavefield at that plane evaluated at the position, $r_2$.

For a single coherent pulse, the summation consists of a single wavefield.

In the present document, the terms "electromagnetic radiation", "radiation" and "beam" are used to encompass all types of electromagnetic radiation, including light, ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

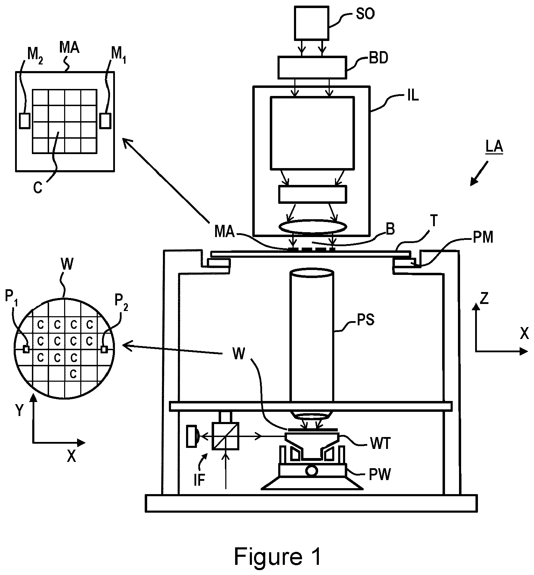

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

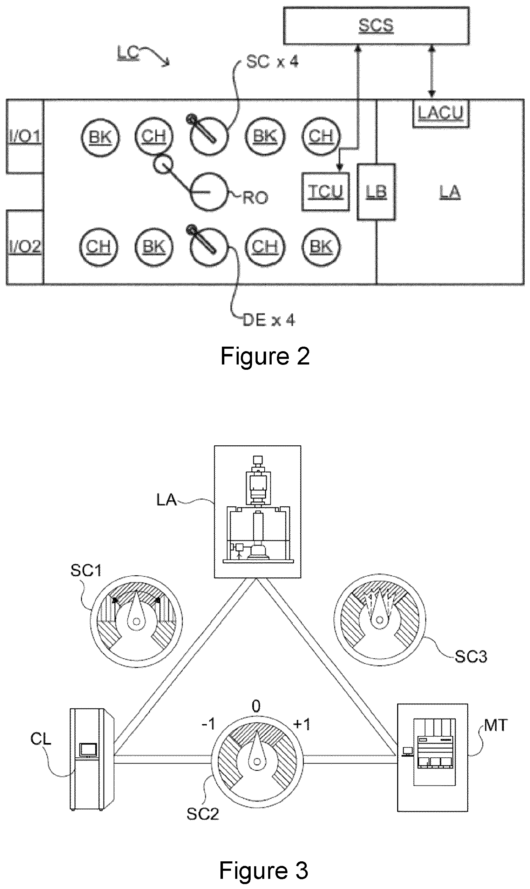

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically, the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically, the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

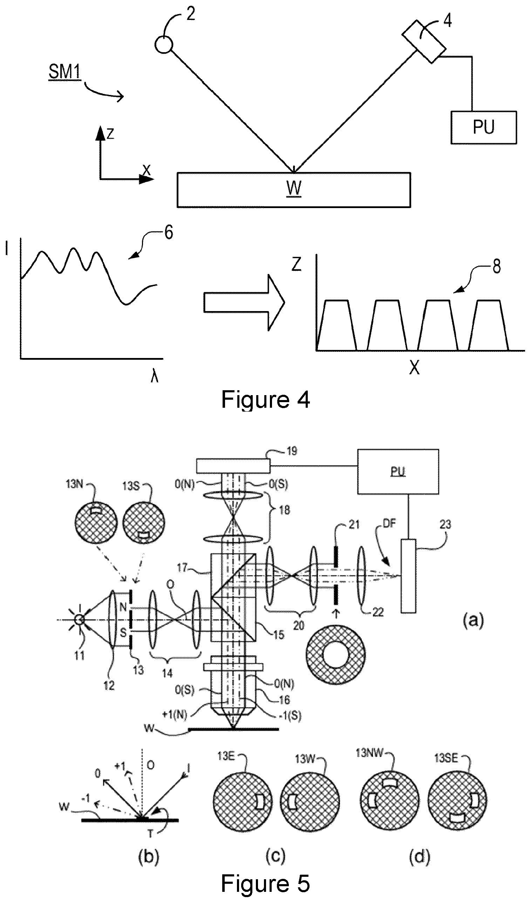

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

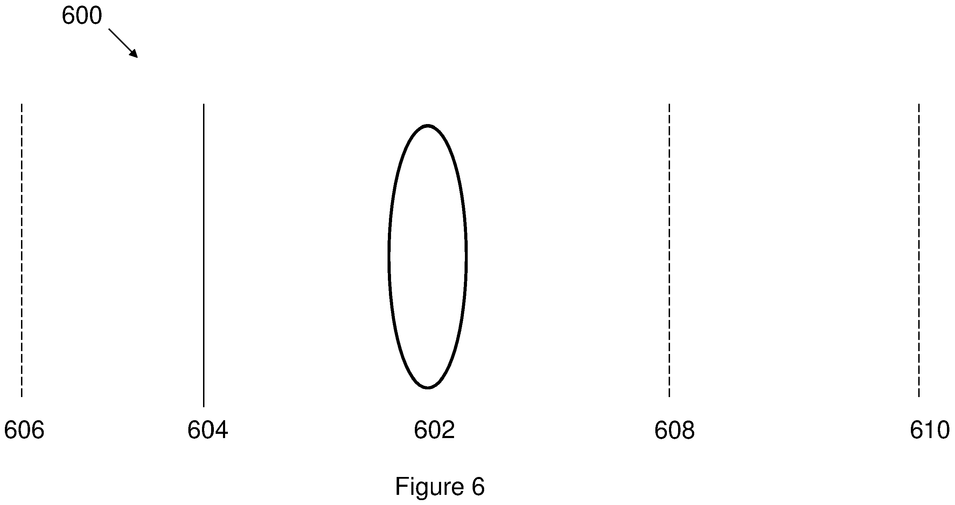

Figure 6 is a schematic illustration of a portion of an electromagnetic system 600. The portion of the electromagnetic system 600 includes a lens element 602, an object plane 604 in which an object (e.g., a fabrication product) is arranged, an entrance pupil plane 606 at minus infinity (i.e. a position which is treated as minus infinity), an exit pupil plane 608 at the back focal plane of the lens element, and an image plane 610 at infinity (i.e. a position which is treated as infinity). Electromagnetic radiation propagates from the entrance pupil to the exit pupil along a radiation path which passes through the lens element 602. Although this radiation path is depicted as being along a straight axis (i.e. the left-right direction in Figure 6), the electromagnetic system may include one or more elements such as mirrors which deflect the radiation path. The lens element 602 can be described as an aberration element. The aberration element causes aberrations in the electromagnetic radiation (e.g., light) which propagates therethrough. The aberrations are described by an aberration function. The object is located on the optical path and interacts with the electromagnetic radiation. The electromagnetic system may be an optical system.

In some examples, the object is a product of a lithographic fabrication system, such as a wafer with a metrology target applied thereon.

In some examples, the object plane 604 is in the front focal plane of lens element 602. In other examples, the electromagnetic radiation may be defocused at the object plane 604.

In some examples, the exit pupil plane 608 is in a front focal plane of a further lens element along the optical path.

In some examples, the electromagnetic system is a metrology apparatus (which may, for example, be a scatterometer as described above with reference to Figs 4 or 5, or the scatterometers of any of the documents referenced above), but it may equally be any other electromagnetic system, for example a lithographic apparatus (such as the lithographic apparatus described above with reference to Figs. 1 to 3).

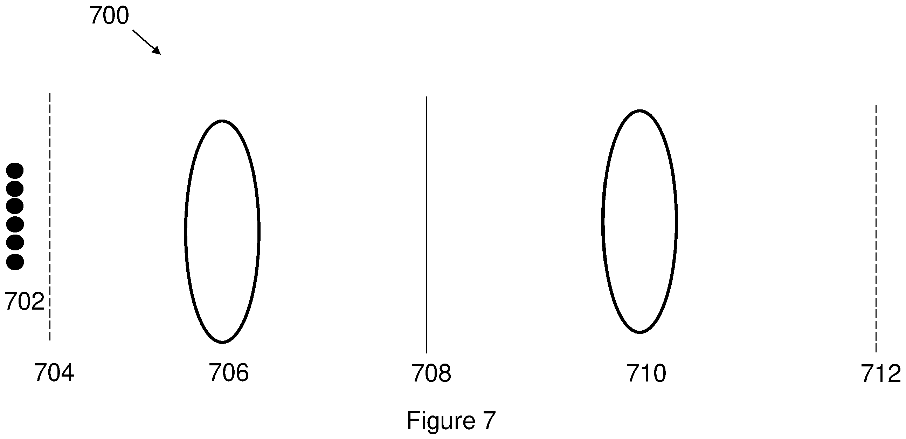

The illumination configuration may be generated by a source of coherent, incoherent, or partially incoherent electromagnetic radiation. That is, a single coherent impulse (delta function), a plurality of coherent impulses each being incoherent with respect to one another, or a plurality of coherent impulses each being partially incoherent with respect to one another. Partially incoherent here means a residual coherence of less than 1%. Modelling of impulses with residual coherency greater than 1% is possible but requires summation over pairs of impulses, which is more computationally expensive. The radiation is modelled as incoherent at a plane referred to as the "incoherent plane". In a specific example, the source is a laser produced plasma source (LPPS) configured to emit light pulses. The light pulses enter the optical system through a multimode fibre. The incoherent plane in the optical system can be at either the fibre near-field plane or the fibre pupil plane. The fibre near-field plane is a plane in the fibre model in Figure 7 that is (optically) conjugate to the spot size selector (SSS) field plane. The SSS field plane is an aperture plane to truncate the light that enters the electromagnetic system (e.g., metrology apparatus). The fibre pupil plane is a plane in the fibre model in Figure 7 that is (optically) conjugate to a pupil plane in the electromagnetic system (e.g., metrology apparatus). Without wishing to be bound by the theory, an incoherent fibre near-field plane is expected to be more accurate for modelling aberrations in optical systems because, in general, optical systems are designed to have less aberration dependence on the field than the pupil (sine condition).

An inhomogeneity in the intensity of the light produced by the LPSS can be measured and incorporated into the model. For example, the intensity of the light from the LPSS can be modelled to decay linearly (or exponentially or by any other function) from the centre to the edge. In a specific example, the intensity decays by e.g. 20%-15% from the centre to the edge.

Figure 7 shows a schematic illustration of a 4-f fibre model 700 (one example of a possible implementation of the invention) used to model the propagation of the coherent, incoherent or partially incoherent electromagnetic radiation from the incoherent plane to an aperture plane, acting as an entrance point (referred to herein as spot size selector) to the electromagnetic system. The system may be a metrology apparatus such as the one shown in Figure 5(a), having an illumination branch and a detection branch.

The model shows how incoherent pulses of electromagnetic radiation from incoherent point sources 702 propagate from the fibre near-field plane 704 to the spot size selector (SSS) 712 via a first fibre lens 706, a fibre aperture 708 and a second fibre lens 710.

The fibre near field plane 704, first fibre lens 706, fibre aperture 708, second fibre lens 710 and SSS 712 are uniformly spaced by a distance, f (a focal length of the fibre lenses). Assuming the fibre field plane is incoherent, electromagnetic radiation passes through the fibre aperture is transformed into a partial coherence function (e.g. Jinc) at the SSS 712. A field-dependent fibre far field inhomogeneity mask can be applied at the fibre aperture plane in order to account for far field intensity inhomogeneity.

In some examples, the illumination configuration is modelled as a plurality of delta functions that are independently propagated to the exit pupil plane 608 and summed incoherently according to the Abbe formalism of partial coherence propagation. As already mentioned, the pulses (i.e., delta functions) can be sampled from the pupil or field plane of the fibre.

In some examples, the sampling of pulses is set according to the Rayleigh condition so that the intensity varies homogenously according to the field and pupil.

In a real system, the wave generated by these pulses (i.e., delta functions) diffracts as it passes through apertures and the like in the optical system, or is otherwise distorted.

In implementations where the fibre field plane is sampled with pulses, each pulse spreads out to form a wavelet on the object plane (e.g., the wafer).

In implementations where the fibre pupil plane is sampled with pulses, each pulse spreads out to form a wavelet on the entrance pupil plane 606.

Following the sine condition in the scalar approximation, it can be demonstrated that the propagation of electromagnetic radiation between the object plane 604 (obj) and the exit pupil plane 608 (XP) through a lens element 602 without aberrations is described by a Fourier transform. That is:

$$E_{XP}(\vec{r}_{XP}) = A_{XP}(\vec{r}_{XP})\sqrt{\cos\alpha_{XP}} \int E_{obj}(\vec{h}_{obj}) e^{-i2\pi\frac{\vec{r}_{XP}}{\lambda f}\cdot\vec{h}_{obj}} d\vec{h}_{obj}$$

Where $r_{xp}$ are coordinates in the exit pupil plane 608, $h_{obj}$ are coordinates of a point source in the object plane, $A_{XP}$ is the shape function with an aperture vector ($\rho$) defined at the exit pupil, $\cos(\alpha_{XP})$ is a cosine factor equal to $\sqrt{1 - \frac{r_{xp}^2}{f^2}}$, and $f$ is the focal length of lens element 602.

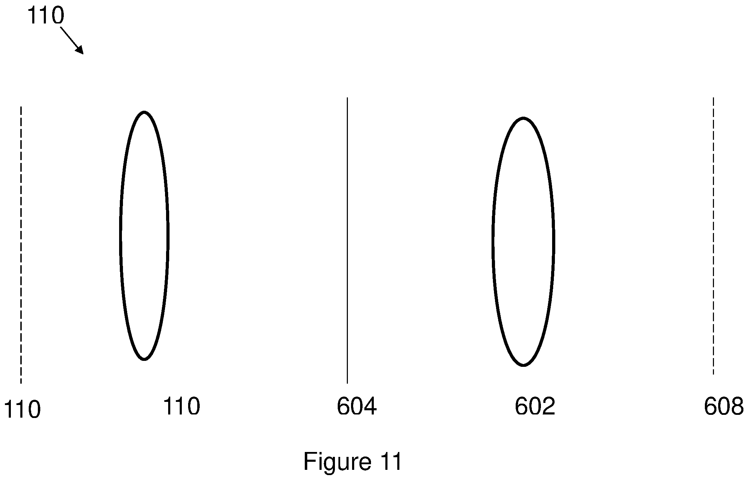

Similar expressions can be derived for other portions of the optical system. For example, between an entrance pupil of the objective lens 1104 as part of the illumination branch (as shown in Figure 11 for example) and an image on the wafer in the object plane. These expressions are set out below.

Aberrations in the propagation of electromagnetic radiation between the entrance pupil plane 606 (EP) and exit pupil plane 608 are described by geometrical optics. For an entrance pupil plane 606 arranged at minus infinity, the electric field ($E_{XP}$) at the exit pupil plane 608 can be shown to be:

$$E_{XP}(\vec{r}_{XP}) = \sqrt{det\left(\frac{\partial\vec{r}_{EP}}{\partial\vec{r}_{XP}}(\vec{r}_{XP})\right)} A_{XP}(\vec{r}_{XP},\vec{h}_{obj}) e^{i\frac{2\pi}{\lambda}W_{XP}(\vec{r}_{XP},\vec{h}_{obj})}\sqrt{\cos\alpha_{EP}}\, e^{-i2\pi\frac{\vec{r}_{XP}}{\lambda f}\cdot\vec{h}_{obj}}$$

where $r_{EP}$ is the entrance pupil coordinate, $W_{XP}$ is the wavefront error with the aperture vector defined at the exit pupil plane 608, $\cos(\alpha_{EP})$ is a cosine factor equal to $\sqrt{1 - \frac{r_{EP}^2}{f^2}}$, and $\vec{h}_{obj}$ is the location of a point source on the object plane.

In some examples, the exit pupil plane 608 is determined from a paraxial ray trace. In other examples, the exit pupil plane is determined from a non-paraxial ray trace and the exit pupil shape is distorted by field dependent aberrations in the optical system.

It can also be demonstrated that the coordinates in the exit pupil plane 608 are distorted with respect to the entrance pupil plane 606 according to a gradient of a pupil aberration function ($\overline{W_{XP}}$) with respect to the position at the object plane. That is:

$$\vec{r}_{EP} = \vec{r}_{XP} - f\nabla_h\overline{W}_{XP}(\vec{r}_{XP},\vec{h}_{obj})$$

Ray tracers are able to calculate wavefront errors for point sources. In practice, however, the electric field at the object plane in real optical systems is spatially extended. The electric field in the exit pupil plane 608 can be determined by summing electric field contributions associated with a plurality of point sources at the object plane with position, $h_{obj}$. Mathematically:

$$E_{XP}(\vec{r}_{XP}) = \int \sqrt{det\left(\frac{\partial\vec{r}_{EP}}{\partial\vec{r}_{XP}}(r_{XP})\right)} A_{XP}(\vec{r}_{XP},\vec{h}_{obj}) e^{i\frac{2\pi}{\lambda}W_{XP}(\vec{r}_{XP},h_{obj})} e^{-i2\pi\frac{\vec{r}_{XP}}{\lambda f}\cdot\vec{h}_{obj}}\sqrt{\cos\alpha_{EP}}\, E_{obj}(\vec{h}_{obj}) d\vec{h}_{obj}$$

As can be seen, the Fourier transform relationship between the electric field at the object plane and the electric field at the exit pupil plane breaks down. This is because the wavefront error ($W_{XP}$) depends on both field position in the object plane and pupil position in the exit pupil plane. The evaluation of this integral is more computationally expensive to evaluate than a Fourier transform.

The present document seeks to address this problem in two different ways: 1) "local field isoplanatism" and 2) "local pupil isoplanatism".

### 1. Local field isoplanatism

In local field isoplanatism, the illumination configuration is a plurality of delta functions independently propagated from the fibre field plane. Each delta function or impulse generates a respective wavelet in the object plane. Each wavelet is localized around a respective centre point, $h_i$. The centre point can be determined according to the centre of the energy density of the wavelet and/or with a ray optics model (e.g., as the paraxial image of the delta function on the fibre field plane). In an example, the wavelet is modelled as an Abbe wavelet. The sampling may be set according to the Rayleigh condition. There are two variants of local field isoplanatism: $0^{th}$ order and $1^{st}$ order.

### $0^{th}$ order local field isoplanatism

In zeroth order local field isoplanatism, the following approximations are made:

$$W_{XP}(\vec{r}_{XP}, \vec{h}_{obj}) = W_{XP}(\vec{r}_{XP}, \vec{h}^i),$$

$$A_{XP}(\vec{r}_{XP}, h_{obj}) = A_{XP}(\vec{r}_{XP}, \vec{h}^i),$$

$$\vec{r}_{EP} = \vec{r}_{XP},$$

More specifically, for a given position in the exit pupil plane 608, the wavefront error depends only a centre position of the wavelet in the object plane 602. Likewise, for a given position in the exit pupil 608, the shape function $A_{XP}$ (or vignetting function) depends only on the centre position of the wavelet in the object plane 602. As the wavefront error does not depend on the position at the object plane (for each position within the wavelet, the aberration is evaluated at the centre position), the entrance and exit pupil coordinates map onto one another without any distortion. In other words, in zeroth order local field isoplanatism, pupil aberrations are modelled as zero.

It can be shown that zeroth order local field isoplanatism leads to the following relationship between the electric field at the exit pupil plane and the electric field at the object plane. The Fourier transform relationship between the electric field at the exit pupil and the electric field at the object plane is restored.

$$E_{XP}(\vec{r}_{XP}) = A_{XP}(\vec{r}_{XP}, \vec{h}^i) e^{i\frac{2\pi}{\lambda}W_{XP}(\vec{r}_{XP}, \vec{h}^i)} \sqrt{\cos \alpha_{XP}} \int E_{obj}(\vec{h}_{obj}) e^{-i2\pi \frac{\vec{r}_{XP}}{\lambda f} \vec{h}_{obj}} d\vec{h}_{obj}.$$

The electric field at a given position in the exit pupil plane 608 can then be determined by computing the Fourier transform of the electric field at the object plane 604 and modifying the result in phase according to the wavefront error, $W_{XP}$ ($r_{XP}$, $h_i$) at the position in the exit pupil plane 608. This can be thought of as applying a phase mask to the electric field generated by each wavelet at the exit pupil plane (absent aberrations in the optical system). Computation of the electric field at the exit pupil plane is much more efficient. The cosine and shape function can also be applied to modify the magnitude of the electric field at the exit pupil plane.

### $1^{st}$ order local field isoplanatism

In first order local field isoplanatism, the following approximations are made:

$$W_{XP}(\vec{r}_{XP}, \vec{h}_{obj}) = W_{XP}(\vec{r}_{XP}, \vec{h}^i) + \nabla_h W_{XP}(\vec{r}_{XP}, h^i) \cdot (\vec{h}_{obj} - \vec{h}^i) \approx W_{XP}(\vec{r}_{XP}, \vec{h}^i) + \nabla_h \overline{W}_{XP}(\vec{r}_{XP}, \vec{h}^i) \cdot (\vec{h}_{obj} - \vec{h}^i),$$

$$A_{XP}\left(\vec{r}_{XP}, \vec{h}_{obj}\right) = A_{XP}\left(\vec{r}_{XP}, \vec{h}^i\right),$$

$$\vec{r}_{EP} = \vec{r}_{XP} - f\nabla_h \overline{W}_{XP}\left(\vec{r}_{XP}, \vec{h}^i\right).$$

More specifically, for a given exit pupil position, the wavefront error depends only on the zeroth order term and an extrapolated change in the wavefront error from the centre position according to the gradient of the wavefront error at the centre position. For a given position in the exit pupil, the shape function $A_{XP}$ or vignetting function depends only on the centre position of the wavelet in the object plane 604 (as with the zeroth order approximation). For a given exit pupil coordinate, a mapping to the entrance pupil coordinate can be carried out by distorting the exit pupil coordinate according to the gradient of the wavefront error evaluated at the centre position of the wavelet. As the gradient in the wavefront error is observed to result in pupil distortion, it is denoted as a pupil aberration, $\overline{W}_{XP}$.

The first order local field isoplanatism approximation can be shown to be equivalent to the following expressions:

$$E(\vec{r}_{XP}) = A_{XP}\left(\vec{r}_{XP}, \vec{h}^i\right)e^{i\frac{2\pi}{\lambda}\left(W\left(\vec{r}_{XP}, \vec{h}^i\right) - \nabla_h W\left(\vec{r}_{XP}, \vec{h}^i\right) \cdot \vec{h}^i\right)}\sqrt{det\left(\frac{\partial \vec{r}_{EP}}{\partial \vec{r}_{XP}}(\vec{r}_{XP})\right)}\sqrt{cos\, \alpha_{EP}} \int E_{obj}(\vec{h})e^{-i2\pi \frac{\vec{r}_{EP}(\vec{r}_{XP}) \cdot \vec{h}}{\lambda f}}\, d\vec{h}.$$

Where $E_{EP}$ is the electric field at the entrance pupil plane 604. The latter can be thought of as being equivalent to applying a phase mask and a deformation mask to the electric field generated by each wavelet at the exit pupil plane 608 (absent aberrations). As the Fourier transform relationship between the electric field at the object and exit pupil plane is restored, computation of the electric field at the exit pupil plane is made much more efficient. The cosine and shape function can also be applied to (further) modify the magnitude of the electric field at the exit pupil plane.

In some implementations, the Fourier transform of the electric field in the object field is computed to obtain the electric field on the entrance pupil. The positions in the entrance pupil plane 608 are then mapped to the exit pupil positions based on the above gradient in the pupil aberration function. The shape function can then be applied to modify the magnitude of the electric field at the exit pupil plane 608.

In some implementations, the position in the entrance pupil plane 608, for a given position in the exit pupil plane 608, is determined based on the above gradient in the pupil aberration function. The Fourier transform of the electric field in the object plane, for a given position in the exit pupil plane 608 is then computed based on the evaluated entrance pupil plane positions. The remaining terms outside the integral (e.g., a vignetting function, cosine factor etc.) can then be applied.

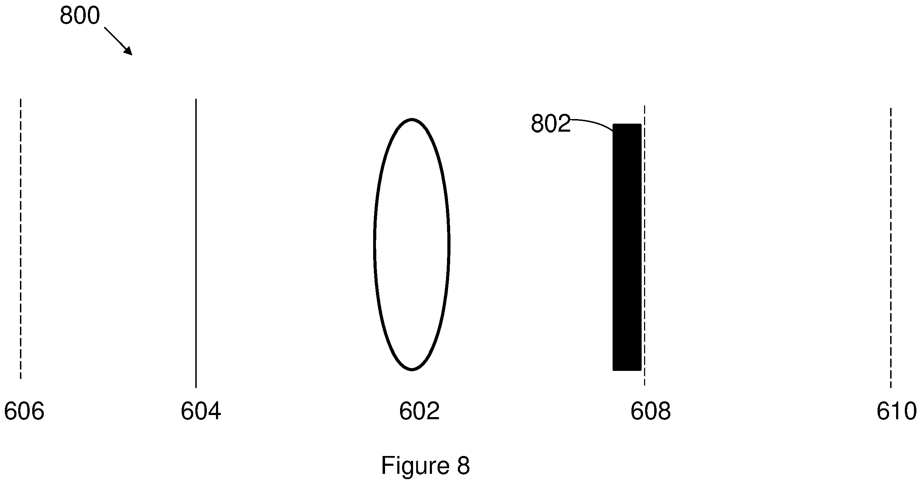

Figure 8 is a schematic illustration of the part of the electromagnetic system 800 shown in Figure 6, with a phase and/or deformation mask 802 applied at the exit pupil. Zeroth order local field isoplanatism corresponds to applying a phase mask only at the exit pupil, whereas first order local field isoplanatism corresponds to applying both a phase and deformation mask at the exit pupil.

Under local field isoplanatism, it can be demonstrated that:

$$E_{wafer}(\vec{h}) =$$
$$\int \frac{1}{\sqrt{det\left(\frac{\partial \vec{r}_{XP}}{\partial \vec{r}_{EP}}(\vec{r}_{XP})\right)}} A_{EP}\left(\vec{r}_{EP}(\vec{r}_{XP}), \vec{h}^i_{wfr}\right)e^{i\frac{2\pi}{\lambda}\left(W_{EP}\left(\vec{r}_{EP}(r_{XP}), \vec{h}^i_{wfr}\right) - \nabla_h \overline{W}_{EP}\left(\vec{r}_{EP}(\vec{r}_{XP}), \vec{h}^i_{wfr}\right) \cdot \vec{h}^i_{wfr}\right)} \frac{1}{\sqrt{cos\, \alpha_{XP}}} e^{-i2\pi \frac{\vec{r}_{XP} \cdot \vec{h}}{\lambda f}} E_{EP}\left(\vec{r}_{EP}(\vec{r}_{XP})\right)d\vec{r}_X$$

Where $E_{wafer}$ is the electric field at position coordinate, h, at the wafer; $h_{wfr}$ is the centre position of the wavelet; $A_{EP}$ is the shape/vignetting function with an aperture vector defined at the entrance pupil; $W_{EP}$ is the wavefront error (field aberration) with the aperture vector defined at the entrance pupil plane; $\overline{W}_{EP}$) is the pupil aberration function with the aperture vector defined at the entrance pupil plane. In the absence of aberrations, the expression relating the electric field at the wafer and entrance pupil is:

$$E_{wafer}(\vec{h}) = \int \frac{1}{\sqrt{cos\, \alpha_{EP}}} e^{-i2\pi \frac{\vec{r}_{EP} \cdot \vec{h}}{\lambda f}} E_{EP}(\vec{r}_{EP}))d\vec{r}_{EP}$$

2. Local pupil isoplanatism

In local pupil isoplanatism, the illumination configuration includes a plurality of delta functions independently propagated from the fibre pupil plane. Each delta function or impulse generates a respective wavelet in the entrance pupil plane 606. As with local field isoplanatism, each pulse generates a respective wavelet, which is localized around a centre point (but in this case in the entrance pupil plane 606). The centre point can be evaluated as the centre of the energy density of the wavelet or it can be evaluated with a ray optics model (e.g., as the paraxial image of the delta function on the fibre pupil plane). In an example, the wavelet is modelled as an Abbe wavelet and the sampling can be set according to the Rayleigh condition.

In zeroth order local pupil isoplanatism, the same approximations are made as for zeroth local field isoplanatism, except that the wavefront error $W_{xp}$ is modelled to depend on the position in the object plane, $h_{obj}$, and only on the centre of the wavelet at the exit pupil plane 608. Field aberrations are zero.

It can be demonstrated that zeroth order local pupil isoplanatism leads to the following equation:

$$E_{XP}(\vec{r}_{XP}) = \int P_{4D}(\vec{r}_{XP}, \vec{h}_{obj}) E_{obj}(\vec{h}_{obj}) e^{i\vec{r}_{XP}\cdot\vec{h}_{obj}} d\vec{h}_{obj} = \int P_{4D}(\vec{r}_{XP}^i, \vec{h}_{obj}) E_{obj}(\vec{h}_{obj}) e^{i\vec{r}_{XP}\cdot\vec{h}_{obj}} d\vec{h}_{obj}.$$

where $P(r_{xp}^i, h_{obj})$ contains the aberration function. This expression can be thought of as being equivalent to applying, for each wavelet, a phase mask to the electric field at the object plane 604 and then propagating the resulting wave to the exit pupil plane 608. Local pupil isoplanatism also advantageous maintains a Fourier transform relationship between the object and exit pupil planes in the electromagnetic system.

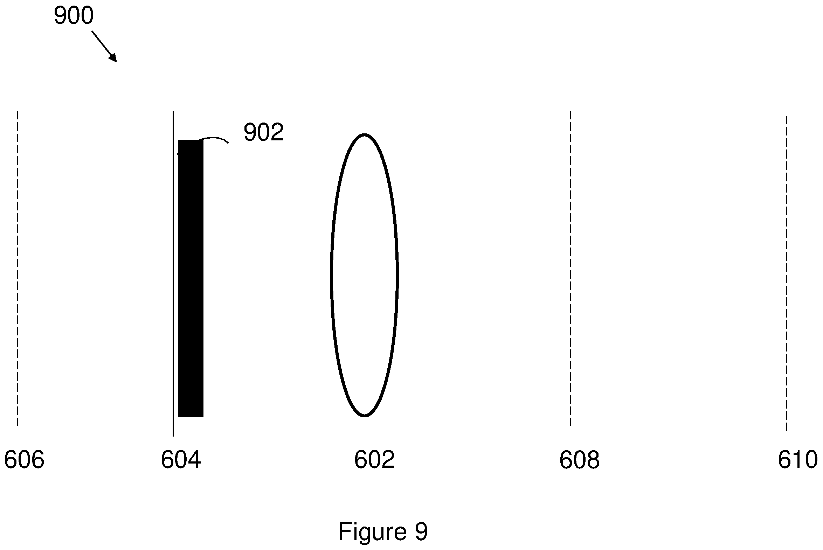

Figure 9 is a schematic illustration of the part of the electromagnetic system 900 shown in Figure 6, with a phase mask 902 applied at the object plane. This corresponds to zeroth order local pupil isoplanatism.

The equations derived for the electric field at the exit pupil plane may also be referred to as optical forward solvers (since they produce a predicted optical response to electromagnetic radiation propagating along the optical path in the optical system). The forward solvers may be used as a component in CD metrology algorithms, iterative digital aberration correction algorithms or in D4c applications.

The local isoplanatism approximation (at either the pupil or field planes) simulates the optical response in optical systems well provided the aberration function does not vary significantly over the wavelet localized at the pupil or object plane, as the case may be. In other words, the approximation is a good one where, for a given exit pupil position, the evaluation of the aberration function across positions in the wavelet is expected to be broadly the same (e.g., deviate by less than 10%).

It is noted that larger apertures in the electromagnetic system lead to more localized wavelets at the pupil or field plane. The use of such apertures can be useful in ensuring the local isoplanatism approximation is a good one. Lower field-dependent aberrations are also preferable for more accurate simulations.

Comparison between local field and local pupil isoplanatism

The differences and similarities between local field and local pupil isoplanatism (LFI, LPI) are as follows:

- The incoherent source is at the fibre field plane for LFI and at the pupil plane for LPI.
- Field aberrations are non-isoplanatic for LFI and isoplanatic for LPI.
- Pupil aberrations for LFI are partially non-isoplanatic and non-isoplanatic for LPI. Expansions of the aberration function

The wavefront error can be expressed in terms of a Hopkins wavefront expansion. This describes rotationally symmetric optics. Mathematically:

$$W(\vec{H}, \vec{\rho}) = \sum_{j,m,n} W_{klm} |\vec{H}|^{k-m} |\vec{\rho}|^{l-m} (\vec{H}\cdot\vec{\rho})^m, \quad \text{with} \quad k = 2j + m, \ l = 2n + m.$$

Where, $W_{klm}$ is the Hopkins wavefront expansion coefficient in unit of waves, H is the position coordinate for the object plane normalized by the spot radius (i.e., $\frac{h_{obj}}{h_{\max\_object}}$), and $\rho$ is the normalized position coordinate for the pupil plane (i.e., $\frac{NA}{NA_{obj}}$).

Rotationally asymmetric optics can have one or more off-axis nodal points. A nodal point shift can be described by adding on-axis Zernikes. That is:

$$W(\vec{H}, \vec{\rho}) = \sum_{j,m,n} W_{klm} |\vec{H}|^{k-m} |\vec{\rho}|^{l-m} (\vec{H} \cdot \vec{\rho})^m + \sum_i c_i Z_i(\vec{\rho}), \quad \text{with} \quad k = 2j + m, \quad l = 2n + m,$$

Where, $c_i$ is the fringe Zernike coefficients in waves, and $Z_i$ is the dimensionless fringe Zernike polynomial.

Alternatively, aberrations can be expressed in field-dependent fringe Zernike coefficients, as follows:

$$W = \sum_n c_n(x, y) Z_n \left( |\vec{\rho}|, atan2(\rho_y, \rho_x) \right),$$

Where $c_n$ is the field dependent expansion coefficients in units of waves, $Z_n$ is the unitless Zernike polynomial defined up to the edge of the aperture, and atan2 is an angle measure between the x-axis and the coordinate $\rho_x$, $\rho_y$.

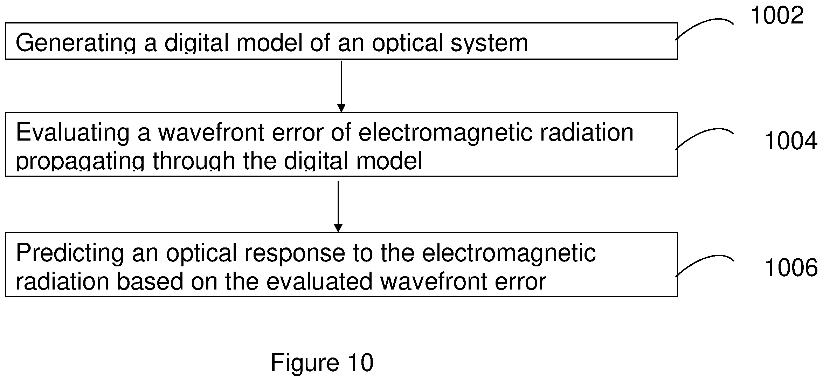

A workflow for designing, simulating and testing a portion of an optical system is now described, with reference to Figure 10.

In step 1002, a digital model representing an optical system is created. In an example, the digital model is of a metrology apparatus, having a wafer with a target of predetermined pattern is arranged at the object plane.

In step 1004, the wavefront error of electromagnetic radiation from the illumination configuration is evaluated using a ray tracer. While the ray tracer can, in principle, produce a micro-diffraction based overlay (uDBO) image in a field plane (as opposed to a DBO in a pupil plane), it does not take into account diffraction and so is not particularly accurate. Alternatively, where the optical model is a digital twin, the wavefront error can be measured using optical metrology. The target can be printed using an appropriate mask and lithographic apparatus.

The wavefront error is measured with respect to a reference sphere that crosses the optical axis at the exit pupil plane and which is centred on the ideal image of the point object. The ideal image point is the image point obtained from a paraxial ray trace. The local and size of the exit pupil is determined from a paraxial ray trace.

The pupil aberration function is defined relative to a reference sphere that crosses the optical axis at the image plane and that is centred on the exit pupil coordinate. Pupil aberrations can be obtained from ray tracers.

In step 1006, the optical response to the illumination configuration is predicted based on the wavefront error from step 1004. Any of the optical forward solvers described above (i.e. 0th, 1st order local field isoplanatism or 0th order local pupil isoplanatism) can be used to predict the optical response. In an example, the optical response is a uDBO image. As the optical forward solvers take into account the effect of diffraction, they are more accurate than ray tracers in predicting uDBO images.

Ann optional further step may be performed in which uDBO images measured using the real optical system.

The predicted uDBO image can be compared with the uDBO image expected for the optical system, absent aberrations. The difference between the images can be recognized as being attributed to aberrations in the optical system. This is useful because differences between a real uDBO image of the predetermined target pattern and the image predicted by the optical forward solver above can be attributed to imperfections in target print quality. Printing parameters for the lithographic apparatus can then be more appropriately adjusted to achieve more optimal print qualities.

The predicted uDBO images may be analysed using a pattern recognition algorithm to obtain application KPIs, such as overlay or target sigma. The application KPIs output can be used as inputs to design and model further optical systems. For example, a target with a different pattern.

The optical system may include further aberration elements upstream to, or downstream of the part of the optical system 600 shown in Figure 6. For example, the optical system may include one or more further aberration elements upstream to the object plane 604 in Figure 6 (which form an illumination branch of the optical system) and/or one or more further aberration elements downstream to the lens element 602 in Figure 6 (which form a detection branch of the optical system). The optical response of each branch can be modelled separately.

Figure 11 is a schematic illustration of the portion of the electromagnetic system between the exit pupil of the illumination branch 1102 and the exit pupil 608 of lens element 602. As discussed above, in the metrology apparatus of Figure 5(a), the illumination branch and detection branch overlap and the object at the object plane is imaged in a reflection mode. That is, electromagnetic radiation propagating through the system is reflected by the object (e.g., patterned wafer) at the object plane 604 so that it passes through a first lens element 1104 and a second lens element 602. In the model of Figure 11 the detection branch is "folded back", to give a notional optical path generally from left-to-right in the figure. In this example, lens elements 1104, 602 are the same and both correspond to the objective lens 602. That is, the first lens element 1104 is the objective lens considered as part of the illumination branch and the second lens element 602 is the objective lens considered as part of the detection branch.

Use cases

The forward solvers described above can be used to compute the electric field transmitted or reflected by a lithography mask on a wafer. These electrical fields distort the pattern formed on the wafer, which is undesirable. Other causes of aberration and diffraction effects which also distort the pattern on the wafer can also be modelled. The forward solvers described above can then be used to predict a wafer pattern for a plurality of different mask designs, each mask design being adapted to produce the same, desired wafer pattern. The mask design with the least distortion (i.e., most closely matching the predetermined wafer pattern) can be selected and, optionally, manufactured.

The forward solvers described above can be used to predict the expected optical response of a metrology apparatus for a given metrology target. This process can be repeated for a plurality of different target configurations. The metrology target predicted to produce: (i) the greatest overlay sensitivity for the metrology system; (ii) the greatest stack sensitivity for the metrology system; and/or (iii) the lowest target sigma for a given parameter (e.g., overlay, intensity inhomogeneities) can then be selected and, optionally, printed.

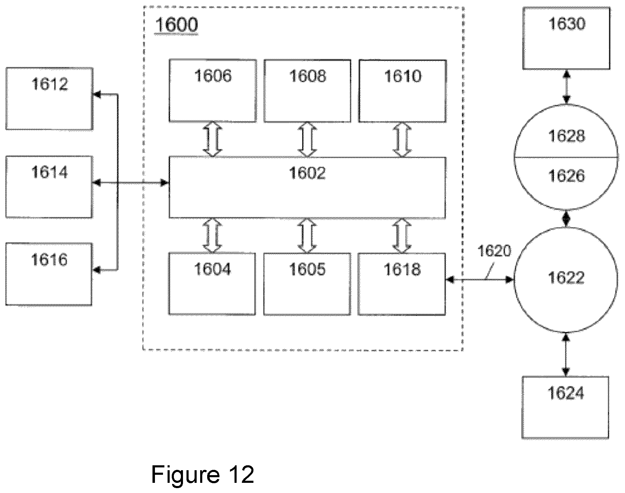

Figure 12 is a block diagram that illustrates a computer system 1600 that may assist in implementing the methods and flows disclosed herein. Computer system 1600 includes a bus 1602 or other communication mechanism for communicating information, and a processor 1604 (or multiple processors 1604 and 1605) coupled with bus 1602 for processing information. Computer system 1600 also includes a main memory 1606, such as a random access memory (RAM) or other dynamic storage device, coupled to bus 1602 for storing information and instructions to be executed by processor 1604. Main memory 1606 also may be used for storing temporary variables or other intermediate information during execution of instructions to be executed by processor 1604. Computer system 1600 further includes a read only memory (ROM) 1608 or other static storage device coupled to bus 1602 for storing static information and instructions for processor 1604. A storage device 1610, such as a magnetic disk or optical disk, is provided and coupled to bus 1602 for storing information and instructions.

Computer system 1600 may be coupled via bus 1602 to a display 1612, such as a cathode ray tube (CRT) or flat panel or touch panel display for displaying information to a computer user. An input device 1614, including alphanumeric and other keys, is coupled to bus 1602 for communicating information and command selections to processor 1604. Another type of user input device is cursor control 1616, such as a mouse, a trackball, or cursor direction keys for communicating direction information and command selections to processor 1604 and for controlling cursor movement on display 1612. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1600 in response to processor 1604 executing one or more sequences of one or more instructions contained in main memory 1606. Such instructions may be read into main memory 1606 from another computer-readable medium, such as storage device 1610. Execution of the sequences of instructions contained in main memory 1606 causes processor 1604 to perform the process steps described herein. One or more processors in a multi-processing arrangement may also be employed to execute the sequences of instructions contained in main memory 1606. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1604 for execution. Such a medium may take many forms, including but not limited to, non-volatile media, volatile media, and transmission media. Non-volatile media include, for example, optical or magnetic disks, such as storage device 1610. Volatile media include dynamic memory, such as main memory 1606. Transmission media include coaxial cables, copper wire and fiber optics, including the wires that comprise bus 1602. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1604 for execution. For example, the instructions may initially be borne on a magnetic disk of a remote computer. The remote computer can load the instructions into its dynamic memory and send the instructions over a telephone line using a modem. A modem local to computer system 1600 can receive the data on the telephone line and use an infrared transmitter to convert the data to an infrared signal. An infrared detector coupled to bus 1602 can receive the data carried in the infrared signal and place the data on bus 1602. Bus 1602 carries the data to main memory 1606, from which processor 1604 retrieves and executes the instructions. The instructions received by main memory 1606 may optionally be stored on storage device 1610 either before or after execution by processor 1604.

Computer system 1600 also preferably includes a communication interface 1618 coupled to bus 1602. Communication interface 1618 provides a two-way data communication coupling to a network link 1620 that is connected to a local network 1622. For example, communication interface 1618 may be an integrated services digital network (ISDN) card or a modem to provide a data communication connection to a corresponding type of telephone line. As another example, communication interface 1618 may be a local area network (LAN) card to provide a data communication connection to a compatible LAN. Wireless links may also be implemented. In any such implementation, communication interface 1618 sends and receives electrical, electromagnetic or optical signals that carry digital data streams representing various types of information.

Network link 1620 typically provides data communication through one or more networks to other data devices. For example, network link 1620 may provide a connection through local network 1622 to a host computer 1624 or to data equipment operated by an Internet Service Provider (ISP) 1626. ISP 1626 in turn provides data communication services through the worldwide packet data communication network, now commonly referred to as the "Internet" 1628. Local network 1622 and Internet 1628 both use electrical, electromagnetic or optical signals that carry digital data streams. The signals through the various networks and the signals on network link 1620 and through communication interface 1618, which carry the digital data to and from computer system 1600, are exemplary forms of carrier waves transporting the information.

Computer system 1600 may send messages and receive data, including program code, through the network(s), network link 1620, and communication interface 1618. In the Internet example, a server 1630 might transmit a requested code for an application program through Internet 1628, ISP 1626, local network 1622 and communication interface 1618. One such downloaded application may provide for one or more of the techniques described herein, for example. The received code may be executed by processor 1604 as it is received, and/or stored in storage device 1610, or other non-volatile storage for later execution. In this manner, computer system 1600 may obtain application code in the form of a carrier wave.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Aspects of the present invention can be summarised according to the following numbered clauses:

Clause 1: A computer-implemented method of predicting a response of an electromagnetic system to electromagnetic radiation from an illumination configuration, the electromagnetic system comprising an aberration element located in a radiation path of the electromagnetic system which causes aberrations described by an aberration function to electromagnetic radiation transmitted along the radiation path, and an object at an object plane on the radiation path which interacts with the electromagnetic radiation, wherein the method comprises: defining a first plane in the electromagnetic system prior to the aberration element along the radiation path in which the electromagnetic radiation forms one (a single wavelet) or a plurality of wavelets, the or each wavelet having a corresponding centre position in the first plane; for the or each wavelet, determining a wavefield for the wavelet, at a second plane in the electromagnetic system after the aberration element along the radiation path based on a Fourier transform of the electric field at the object plane and an expansion of the aberration function based on the corresponding centre position of the wavelet; computing the response according to the wavefield or sum of the wavefields at the second plane.

Clause 2: A method according to clause 1, in which the step of determining the wavefield for the or each wavelet comprises: for each of a plurality of positions in the second plane: evaluating the aberration function with a dependence of the aberration function on the position of the wavelet in the first plane modelled as a zeroth or first order expansion about the centre position of the wavelet in the first plane.

Clause 3: A method according to any preceding clause, in which the step of determining the wavefield for the or each wavelet comprises: for each of a plurality of positions in the second plane: computing a respective Fourier transform of an electric field at the object plane of the electromagnetic system.

Clause 4: A method according to any preceding clause, further comprising, for each of the plurality of positions in the second plane: modifying the computed Fourier transform, at least in phase, based on the evaluated aberration function.

Clause 5: A method according to any preceding clause, in which defining the first plane in which the electromagnetic radiation forms one or the plurality of wavelets comprises: respectively defining one (a single position) or a plurality of positions at a third plane in the electromagnetic system prior to the aberration element along the radiation path, the or each position being associated with an impulse of the illumination configuration and for the or each position in the plurality of positions: determining the corresponding wavelet and its centre position in the first plane according to the optical impulse in the third plane at the position.

Clause 6: A method according to any one of the preceding clauses, wherein the first plane is the object plane and the second plane is an exit pupil plane in the electromagnetic system.

Clause 7: A method according to any one of the preceding clauses, in which the dependence of the aberration function on the position of the wavelet in the first plane is modelled as a first order expansion about the centre position of said wavelet in the first plane, wherein, the or each respective Fourier transform of the electric field at the object plane is computed based on the evaluated aberration function.

Clause 8: A method according to of the preceding clauses, in which the or each respective Fourier transform of the electric field at the object plane is computed using a position in an entrance pupil plane of the electromagnetic system, and each position in the entrance pupil plane is determined based on the position in the second plane and the evaluated aberration function.

Clause 9: A method according to any one of the preceding clauses, in which modifying the computed Fourier transform at least in phase based on the evaluated aberration function comprises modifying the phase of the computed Fourier transform based on the zeroth order term and the first order term of the expansion for the aberration function, and not on any higher order term of the expansion.

Clause 10: A method according to any one of the preceding clauses, in which modifying the computed Fourier transform at least in phase based on the evaluated aberration function comprises modifying the phase of the computed Fourier transform based on the zeroth order term of the expansion for the aberration function, and not on any higher order term of the expansion.

Clause 11: A method according to any one of the preceding clauses, wherein the electromagnetic system is a lithographic apparatus, including a wafer at the object plane, a lithography mask arranged upstream of the object plane on the radiation path, and the aberration element is arranged therebetween.

Clause 12: A method according to any one of the preceding clauses, wherein the electromagnetic system is a metrology apparatus, including a wafer with a metrology target arranged at the object plane and the aberration element is arranged downstream and/or upstream of the object plane.

Clause 13: A method according to any one of the preceding clauses, further comprising: predicting a response of one or more further electromagnetic systems to electromagnetic radiation from the illumination configuration according to the method steps in any one of clauses 1 to 12, wherein each of the further electromagnetic systems includes a different lithography mask arranged upstream of the wafer at the object plane with the aberration element in each case being arranged therebetween; and selecting one of the lithography masks according to the predicted responses.

Clause 14: A method according to any one of the preceding clauses, further comprising: predicting a response of one or more further electromagnetic systems to electromagnetic radiation from the illumination configuration according to the method steps in any one of clauses 1 to 13, wherein each of the further electromagnetic systems includes a wafer with a different metrology target at the object plane; and selecting one of the targets according to the predicted responses.

Clause 15: A method according to any one of the preceding clauses, further comprising: predicting a response of the electromagnetic system to electromagnetic radiation from the illumination configuration, wherein the electromagnetic system is modelled absent aberrations; and comparing the response of the electromagnetic system absent aberrations to the response of the electromagnetic system with aberrations.

Clause 16: A method according to any one of the preceding clauses, wherein the response is a diffraction-based overlay (DBO) image.

Clause 17: A method according to any one of the preceding clauses, wherein each impulse is modelled as a delta function, and each delta function is associated with an Abbe wavelet in the first plane.

Clause 18: A method according to any one of the preceding clauses, further comprising: measuring a response of the electromagnetic system to electromagnetic radiation from the illumination configuration; and comparing the predicted response to the measured electromagnetic response.

Clause 19: A computer-implemented method of predicting an electromagnetic response of an electromagnetic system to an illumination configuration, the electromagnetic system comprising an aberration element located in a radiation path of the electromagnetic system which causes aberrations described by an aberration function to electromagnetic radiation transmitted along the radiation path, and an object at an object plane on the radiation path which interacts with the electromagnetic radiation, wherein the method comprises:

defining a plurality of positions at a first plane in the electromagnetic system prior to the aberration element along the radiation path, each position being associated with an impulse of the illumination configuration;

for each position in the plurality of positions:

determining a corresponding centre position of a wavelet in a second plane of the electromagnetic system prior to the aberration element along the optical path, according to the optical impulse in the first plane at the position;

determining a wavefield, at a third plane in the optical system after the aberration element along the radiation path, the wavefield being associated with the corresponding wavelet, wherein the determining step comprises, at each of a plurality of positions in the third plane:

evaluating an aberration function for the position in the third plane, wherein a dependence of the aberration function on the position of the wavelet in the second plane is modelled as a zeroth or first order expansion about the centre position of said wavelet in the second plane;

computing a respective Fourier transform of an electric field at the object plane of the electromagnetic system; and modifying the computed Fourier transform, at least in phase, based on the evaluated aberration function; and

computing the electromagnetic response according to the sum of the wavefields at the third plane.

Clause 20: A computer program product comprising instructions, which, when executed by a computer processor, causes the computer processor to perform the method steps of any one of clauses 1 to 19.

Clause 21: A computer system, comprising one or more processors configured to perform the method of any of clauses 1 to 19.

**Claims**

1. A computer-implemented method of predicting a response of an electromagnetic system to electromagnetic radiation from an illumination configuration, the electromagnetic system comprising an aberration element located in a radiation path of the electromagnetic system which causes aberrations described by an aberration function to electromagnetic radiation transmitted along the radiation path, and an object at an object plane on the radiation path which interacts with the electromagnetic radiation, wherein the method comprises:

   defining a first plane in the electromagnetic system prior to the aberration element along the radiation path in which the electromagnetic radiation forms a single wavelet or a plurality of wavelets, the or each wavelet having a corresponding centre position in the first plane;

   for the or each wavelet, determining a wavefield for the wavelet, at a second plane in the electromagnetic system after the aberration element along the radiation path based on a Fourier transform of the electric field at the object plane and an expansion of the aberration function based on the corresponding centre position of the wavelet;

   computing the response according to the wavefield or the wavefields.

2. A method according to claim 1, in which the step of determining the wavefield for the or each wavelet comprises:
   for each of a plurality of positions in the second plane:
   evaluating the aberration function with a dependence of the aberration function on the position of the wavelet in the first plane modelled as a zeroth or first order expansion about the centre position of the wavelet in the first plane.

3. A method according to claim 2, in which the step of determining the wavefield for the or each wavelet comprises:
   for each of a plurality of positions in the second plane:
   computing a respective Fourier transform of an electric field at the object plane of the electromagnetic system.

4. A method according to claim 3, further comprising, for each of the plurality of positions in the second plane:
   modifying the computed Fourier transform, at least in phase, based on the evaluated aberration function.

5. A method according to any one of claims 1 to 4, in which defining the first plane in which the electromagnetic radiation forms the single or the plurality of wavelets comprises:
respectively defining a single position or a plurality of positions at a third plane in the electromagnetic system prior to the aberration element along the radiation path, the or each position being associated with an impulse of the illumination configuration and for the or each position in the plurality of positions:
determining the corresponding wavelet and its centre position in the first plane according to the optical impulse in the third plane at the position.

6. A method according to any one of the preceding claims, wherein the first plane is the object plane and the second plane is an exit pupil plane in the electromagnetic system.

7. A method according to any one of the preceding claims, in which the dependence of the aberration function on the position of the wavelet in the first plane is modelled as a first order expansion about the centre position of said wavelet in the first plane,
wherein, the or each respective Fourier transform of the electric field at the object plane is computed based on the evaluated aberration function.

8. A method according to claim 7, in which the or each respective Fourier transform of the electric field at the object plane is computed using a position in an entrance pupil plane of the electromagnetic system, and each position in the entrance pupil plane is determined based on the position in the second plane and the evaluated aberration function.

9. A method according to any one of claims 4 to 8, in which modifying the computed Fourier transform at least in phase based on the evaluated aberration function comprises modifying the phase of the computed Fourier transform based on the zeroth order term and the first order term of the expansion for the aberration function, and not on any higher order term of the expansion.

10. A method according to any one of claims 4 to 8, in which modifying the computed Fourier transform at least in phase based on the evaluated aberration function comprises modifying the phase of the computed Fourier transform based on the zeroth order term of the expansion for the aberration function, and not on any higher order term of the expansion.

11. A method according to any one of the preceding claims, wherein the electromagnetic system is a lithographic apparatus, including a wafer at the object plane, a lithography mask arranged upstream of the object plane on the radiation path, and the aberration element is arranged therebetween.

12. A method according to any one of claims 1 to 10, wherein the electromagnetic system is a metrology apparatus, including a wafer with a metrology target arranged at the object plane.

13. A method according to claim 7, further comprising:

    predicting a response of one or more further electromagnetic systems to electromagnetic radiation from the illumination configuration according to the method steps in claim 1, wherein each of the further electromagnetic systems includes a different lithography mask arranged upstream of the wafer at the object plane with the aberration element in each case being arranged therebetween; and
    selecting one of the lithography masks according to the predicted responses.

14. A method according to claim 12, further comprising:

    predicting a response of one or more further electromagnetic systems to electromagnetic radiation from the illumination configuration according to the method steps in claim 1, wherein each of the further electromagnetic systems includes a wafer with a different metrology target at the object plane; and
    selecting one of the targets according to the predicted responses.

15. A computer program product comprising instructions, which, when executed by a computer processor, causes the computer processor to perform the method steps of any one of claims 1 to 14.

Figure 1

Figure 2

Figure 3

Figure 4

Figure 5

Figure 6

EP 4 481 492 A1

712    710    708    706    704

702

Figure 7

700

24

Figure 8

Figure 9

Generating a digital model of an optical system — 1002

Evaluating a wavefront error of electromagnetic radiation propagating through the digital model — 1004

Predicting an optical response to the electromagnetic radiation based on the evaluated wavefront error — 1006

Figure 10

110

110 110 604 602 608

Figure 11

EP 4 481 492 A1

Figure 12

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MARIO A BELTRAN ET AL: "Aberrated dark-field imaging systems", ARXIV.ORG, CORNELL UNIVERSITY LIBRARY, 201 OLIN LIBRARY CORNELL UNIVERSITY ITHACA, NY 14853, 18 September 2018 (2018-09-18), XP081056932, DOI: 10.1103/PHYSREVA.98.053849 * abstract * * pages 1,2 * | 1-15 | INV. G03F7/00 |
| A | WO 2023/041274 A1 (ASML NETHERLANDS BV [NL]) 23 March 2023 (2023-03-23) * paragraphs [0048] - [0054] * | 1-15 | |
| A | MOAAZ RAUF NIZAMI ET AL: "A wave-optical model for chromatic confocal sensing using multimode fibre incoherent illumination", JOURNAL OF OPTICS, INSTITUTE OF PHYSICS PUBLISHING, BRISTOL GB, vol. 23, no. 11, 18 October 2021 (2021-10-18), page 115608, XP020370545, ISSN: 2040-8986, DOI: 10.1088/2040-8986/AC2879 [retrieved on 2021-10-18] * pages 2,3 * | 1-15 | TECHNICAL FIELDS SEARCHED (IPC)<br><br>G03F |

The present search report has been drawn up for all claims

| Place of search | Date of completion of the search | Examiner |
|---|---|---|
| Munich | 28 November 2023 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

# EP 4 481 492 A1

## ANNEX TO THE EUROPEAN SEARCH REPORT
## ON EUROPEAN PATENT APPLICATION NO.

EP 23 18 0758

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2023

| Patent document cited in search report | Publication date | Patent family member(s) | Publication date |
|---|---|---|---|
| WO 2023041274 A1 | 23-03-2023 | TW 202328822 A<br>WO 2023041274 A1 | 16-07-2023<br>23-03-2023 |

EPO FORM P0459

For more details about this annex : see Official Journal of the European Patent Office, No. 12/82

31

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B

- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1